# EUROPÄISCHE PATENTANMELDUNG

(11) **EP 0 867 931 A1**
(43) Veröffentlichungstag der Anmeldung: **30.09.1998**
(21) Anmeldenummer: 97120315.3
(22) Anmeldetag: 20.11.1997
(51) Int. Cl.: H01L 21/60

(54) **Verfahren zur Herstellung von Lothöckern definierter Grösse**

(30) Priorität: 24.03.1997 DE 19712219
(71) Anmelder: ROBERT BOSCH GMBH, 70442 Stuttgart (DE)
(72) Erfinder: Hauer, Heinz, 70734 Fellbach (DE); Kuke, Albrecht, Dr., 71549 Auenwald (DE); Dutzi, Joachim, Dr., 71554 Weissach (DE)

(57) **Zusammenfassung**

Ein Verfahren zur Herstellung einer von Lot nicht benetzbaren Oxidschicht, wobei man auf einem Substrat eine von Lot benetzbare Kontaktschicht aufbringt und man später zylinderförmige Lotsäulen auf der Kontaktschicht strukturiert und diese anschließend durch Erwärmen in einen Lothöcker von im wesentlichen kugelkappenförmiger Gestalt umschmelzt, umfaßt folgende Schritte: Man bringt auf die Kontaktschicht aus Gold eine von Lot nicht benetzbare, oxidierbare Lotstoppschicht aus Nickel und/oder Chrom auf, welche Öffnungen vorgegebener Größe aufweist, man tempert das Substrat zusammen mit sämtlichen auf ihm aufgebrachten Schichten vor der Strukturierung der Lotsäulen in Luft derart, daß im Übergangsbereich zwischen Lotstoppschicht und Kontaktschicht ein Saum aus einer von Lot nicht benetzbaren Oxidschicht entsteht.

## Beschreibung

### Stand der Technik

Die Erfindung betrifft ein Verfahren zur Herstellung von Lothöckern definierter Größe, wobei man auf einem Substrat eine von Lot benetzbare Kontaktschicht aufbringt und wobei man zylinderförmige Lotsäulen auf der Kontaktschicht strukturiert und diese anschließend durch Erwärmen in einen Lothöcker von im wesentlichen kugelkappenförmiger Gestalt umschmelzt.

Verfahren zur Herstellung von Lothöckern (englisch bumps) definierter Größe sind seit langem bekannt. Derartige Lothöcker dienen beispielsweise der Befestigung und gleichzeitigen Kontaktierung elektronischer oder optoelektronischer Bauelemente-Chips auf einer Trägerplatte oder einem Substrat. Die Lothöcker können dabei sowohl auf der Trägerplatte als auch auf dem zu kontaktierenden Bauelement-Chip aufgebracht sein. Im Bereich der Lothöcker müssen auf der Trägerplatte oder dem Substrat metallische, durch das Lot benetzbare Flächen vorgesehen sein, damit ein guter Lotkontakt beim Auflöten der Bauelemente, beispielsweise der Chips, gewährleistet ist.

Ein derartiges Verfahren ermöglicht auch eine präzise Positionierung von Bauelementen, beispielsweise optoelektronischen Bauelementen, auf der Trägerplatte dadurch, daß das aufzulötende Bauelement durch die Oberflächenspannungskräfte der während des Auflötens flüssigen Lothöcker in eine durch die Kontaktflächen auf der Trägerplatte und dem Bauelement vorgegebene definierte Lage gezogen wird und somit mit hoher Genauigkeit positioniert werden kann (Selbstzentrierung). Kleinere Fehlpositionierungen beim Aufsetzen des Bauelements auf das Substrat oder die Trägerplatte können auf diese Weise selbsttätig korrigiert werden.

Bei derartigen Verfahren zur Herstellung von Lothöckern ist es erforderlich, daß sowohl die mit Lot benetzbare Kontaktschicht als auch eine dem Lothöcker gegenüberliegende Kontaktfläche, beispielsweise eines aufzubringenden Bauelements, hinsichtlich ihrer Benetzbarkeit lateral auf die Größe des Lothöckers begrenzt ist. Andernfalls würde sich beim Umschmelzen der zylinderförmigen Lotsäulen das Lot weiträumig über die Kontaktschicht auf dem Substrat bzw. auf dem aufzubringenden Bauelement verteilen und so eine elektrische Kontaktierung durch Kurzschlüsse verhindern. Auch eine Selbstzentrierung wäre so nicht möglich.

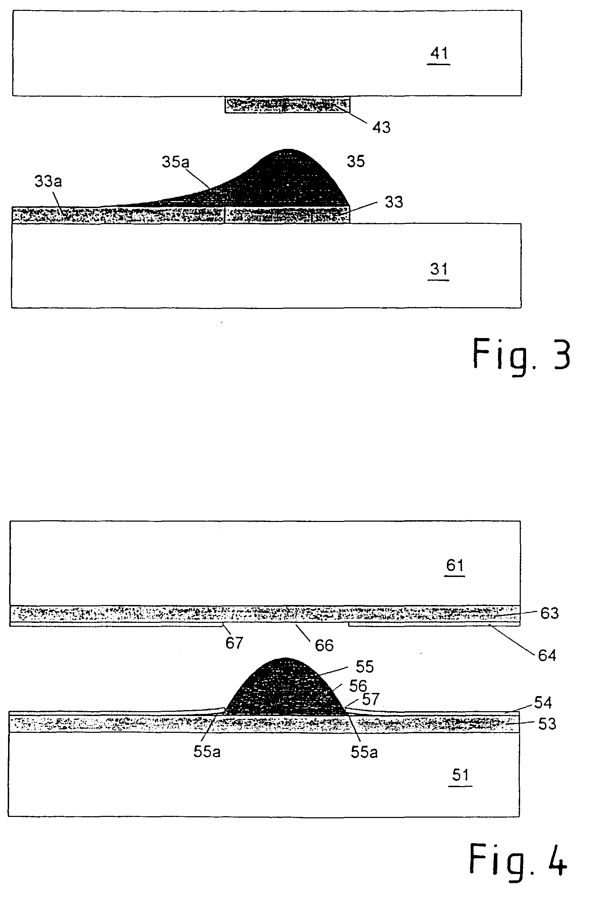

Ein aus dem Stand der Technik bekanntes Verfahren, bei dem die benetzbare Kontaktschicht, auf die der Lothöcker aufgebracht wird, lateral begrenzt ist, sieht vor, daß die benetzbare Kontaktschicht in der Größe der Grundfläche des Lothöckers strukturiert wird. Anhand von Fig. 3 wird ein solches aus dem Stand der Technik bekanntes Verfahren erläutert. Auf einem Substrat 31 ist eine metallische Kontaktschicht 33 aufgebracht und strukturiert. Diese Kontaktschicht 33 hat üblicherweise die Form eines Kreises oder eines regelmäßigen Vielecks. Wenn ein auf sie aufzubringender Lothöcker 35 gleichzeitig zur elektrischen Kontaktierung verwendet werden soll, muß eine strukturierte Stromleitungsbahn 33a zur Grundfläche und zur Kontaktfläche des Lothökkers 35 geführt werden. Mindestens am Übergang von der Stromleitungsbahn 33a zur Kontaktschicht 33 wird die Begrenzung der Kontaktschicht gestört, so daß ohne weitere Maßnahmen Lot vom Lothöcker 35 beim Aufschmelzen auf die Leiterbahn in einer Lotzunge 35a vordringen kann und die laterale und vertikale Positionierung einer Kontaktfläche 43 beispielsweise eines aufzubringenden Chips 41 beeinträchtigt wird.

Aus der US 5 024 372 geht ein Verfahren zur Herstellung von Lothöckern definierter Größe hervor, bei dem begrenzte Kontaktflächen der Kontaktschicht vorgesehen sind, die von Begrenzungsflächen umgeben sind, welche eine laterale Begrenzung für das aufzuschmelzende, über den Kontaktflächen angeordnete säulenförmige Lot darstellen.

Die seitlichen Begrenzungsflächen werden auf fototechnischem Wege hergestellt, sie müssen nach Herstellung der Lothöcker wieder von dem Substrat bzw. der Trägerplatte entfernt werden. Ein derartiges Verfahren zur Herstellung von Lothöckern definierter Größe ist im Hinblick auf eine schnelle und präzise Kontaktierung von Bauelementen problematisch, da es sehr viele Schritte umfaßt.

Ein weiteres, aus dem Stand der Technik bekanntes Verfahren zur Herstellung von Lothöckern definierter Größe wird schließlich in Verbindung mit Fig. 4 erläutert. Bei diesem Verfahren wird über der metallischen Kontaktschicht 53, 63 auf dem Substrat 51 bzw. dem aufzubringenden Chip 61 eine nicht benetzbare Begrenzungsschicht 54 bzw. 64 aufgebracht, in der Öffnungen 56 bzw. 66 vorgegebener Größe vorgesehen sind. Als Begrenzungsschichten 54, 64 sind beispielsweise dielektrische Schichten, z.B. Polyimid (PI), gebräuchlich. Diese Schichten weisen eine Dicke auf, die wesentlich kleiner ist als die Höhe der Lothöcker, da sonst bei einer geringen Fehlpositionierung beim Aufsetzen des aufzubringenden Bauelements ein Kontakt des Lothöckers mit der benetzbaren Kontaktschicht verhindert würde und auch die oben beschriebene Selbstzentrierung des Bauelementes beim Aufbringen nicht mehr möglich wäre. Nachteilig bei diesem Verfahren zur Herstellung von Lothöckern definierter Größe ist, daß Lot 55 beim Umschmelzen und beim Aufschmelzen während der Montage der Bauelemente infolge der erforderlichen guten Benetzung der Kontaktschicht am Rand 57, 67 der Begrenzungsschicht als Lotzunge 55a unter diese Schicht kriecht und sie dadurch anheben kann. Dadurch wird die Positioniergenauigkeit sowohl in lateraler als auch in vertikaler Richtung verschlechtert und die Präzision der Verbindung beeinträchtigt. Eine sehr feine Strukturierung mit vielen eng beieinanderliegenden Lothöckern ist auf diese Weise nicht möglich.

Der Erfindung liegt daher die Aufgabe zugrunde, die oben genannten Nachteile zu beseitigen und ein Verfahren zur Herstellung von Lothöckern definierter Größe der gattungsgemäßen Art derart zu verbessern, daß dieses bei einfacher und schneller Durchführung eine sehr präzise laterale Begrenzung der Lothöcker ermöglicht.

### Vorteile der Erfindung

Diese Aufgabe wird bei einem Verfahren zur Herstellung von Lothöckern definierter Größe der eingangs beschriebenen Art erfindungsgemäß durch die folgenden Schritte gelöst:
Man bringt auf die Kontaktschicht eine von Lot nicht benetzbare, oxidierbare Lotstoppschicht auf, welche Öffnungen vorgegebener Größe aufweist,
man tempert das Substrat zusammen mit sämtlichen auf es aufgebrachten Schichten vor der Strukturierung der Lotsäulen in Luft temperaturgesteuert derart, daß im Übergangsbereich zwischen der Lotstoppschicht und der Kontaktschicht ein Saum aus einer von Lot nicht benetzbaren Oxidschicht durch Lateraldiffusion der Oxide der Lotstoppschicht entsteht.

Die Ausbildung des Saums aus einer von Lot nicht benetzbaren Oxidschicht auf der Lotstoppschicht durch Aufbringen einer oxidierbaren Schicht aus einem oxidierbaren Material mit definierten Öffnungen und anschließendes Tempern des gesamten Schichtenaufbaus aus Substrat, Kontaktschicht und Lotstoppschicht hat den besonders großen Vorteil, daß auf einfache und sehr schnelle Weise eine sehr präzise laterale Begrenzung der Lothöcker erreicht werden kann.

Rein prinzipiell können als Kontaktschichten die unterschiedlichsten metallischen Schichten verwendet werden. Eine vorteilhafte Ausführungsform sieht vor, daß man als Kontaktschicht eine Goldschicht verwendet.

Was die Lotstoppschicht betrifft, so können auch hier unterschiedliche von Lot nicht benetzbare metallische Schichten verwendet werden.

Eine vorteilhafte Ausführungsform sieht die Verwendung einer Chromschicht vor.

Bei einer anderen vorteilhaften Ausführungsform verwendet man als Lotstoppschicht eine Nickelschicht.

Schließlich kann auch eine Nickel/Chromschicht verwendet werden.

Diese Schichten sind sehr gut oxidierbar, wobei sowohl die Lotstoppschicht selbst als auch deren Oxid von Lot nicht benetzbar sind.

Hinsichtlich der Dicke der Kontaktschicht und der Dicke der Lotstoppschicht hat sich eine Dicke von 1 bis 5 µm als vorteilhaft erwiesen.

Die Dicke der Lotstoppschicht beträgt vorzugsweise 0,2 bis 0,5 µm.

Was den Tempervorgang betrifft, so wurden hierzu bislang keine näheren Angaben gemacht. Eine vorteilhafte Ausführungsform sieht vor, daß das Tempern bei Temperaturen zwischen 200 bis 400 °C und über einen Zeitraum von 2 bis 24 Stunden stattfindet.

Die Breite des Saums hängt von der Temperatur und insbesondere auch von der Zeit des Tempervorgangs ab. Mit zunehmender Temperatur und zunehmender Temperzeit kann die Breite des Saums vergrößert werden.

Um insbesondere einen Mehrschichtenaufbau zu ermöglichen, kann bei vorteilhaften Ausführungsformen vorgesehen sein, daß auf die Lotstoppschicht wenigstens eine Polyimid(PI)-Schicht zu Isolationszwecken aufgebracht wird.

### Zeichnung

Weitere Merkmale und Vorteile der Erfindung sind Gegenstand der nachfolgenden Beschreibung, in der Ausführungsbeispiele des Verfahrens in Verbindung mit der Zeichnung näher erläutert werden.

In der Zeichnung zeigen:
- Fig. 1: einen mittels des erfindungsgemäßen Verfahrens auf einem Substrat aufgebrachten Lothöcker;
- Fig. 1a: eine Detailvergrößerung eines in Fig. 1 mit Ia gekennzeichneten Ausschnitts und
- Fig. 2: einen mittels des erfindungsgemäßen Verfahrens auf einem als Träger dienenden Bauelements aufgebrachten Lothöcker kurz vor der Montage auf einer Trägerplatte.

### Beschreibung der Ausführungsbeispiele

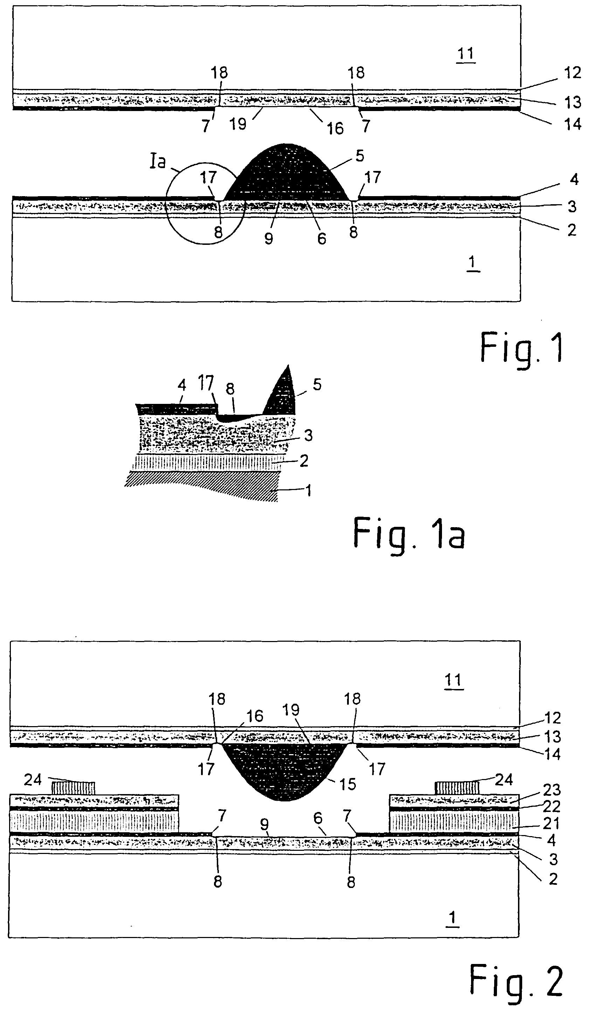

In Fig. 1 ist ein Schichtaufbau für die Kontaktierung mit Lothöckern dargestellt. Sowohl auf einem Substrat 1 als auch auf einem auf diesem aufzubringenden Chip 11 ist über eine Haftvermittlungsschicht 2, 12 jeweils eine Kontaktschicht 3, 13 aufgebracht. Diese Kontaktschichten 3, 13 können strukturiert sein, um verschiedene Strompfade voneinander zu trennen (nicht dargestellt). Die Positionen der Grundflächen 9 bzw. Kontaktflächen 19 für Lothöcker 5 wird durch eine auf den Kontaktschichten 3, 13 jeweils aufgebrachte Lotstoppschicht 4, 14, welche Öffnungen 6, 16 aufweist, definiert. Um das Eindringen des Lotes zwischen die Kontaktschicht 3, 13 und die Lotstoppschicht 4, 14 an Rändern 7, 17 der Öffnung 6, 16 zu verhindern, wird vorgegangen, wie nachfolgend beschrieben.

Zunächst wird ein Schichtaufbau obenerwähnter Schichten hergestellt. Als Substrat 1 kommt Keramik, Silizium oder ein sonstiges gebräuchliches Substratmaterial zum Einsatz. Die Kontaktschicht 3 besteht aus Gold, die Haftvermittlungsschicht 2 aus einem für die Haftung von Gold auf dem Substratmaterial geeigneten Material, wie z.B. Tantalnitrid, Molybdän oder Titan/Wolfram.

Als Lotstoppschicht 4 wird Chrom, Nickel oder Nickel/Chrom verwendet.

Die Lotstoppschichten 2, 4 weisen eine Dicke von 0,2 bis 0,5 µm auf, während die Goldschicht eine Dicke von 1 bis 5 µm aufweist. Zu der Lotstoppschicht 2, 4 sind Öffnungen 6 vorgesehen, die beispielsweise auch nach dem Aufbringen der Lotstoppschicht 2, 4 in dieser strukturiert werden können.

Nachdem dieser Schichtaufbau hergestellt wurde, wird das Substrat zusammen mit den auf ihm aufgebrachten Schichten in Luft bei einer Temperatur von 200 bis 400 °C über einen Zeitraum von 2 bis 24 Stunden getempert. Dabei bildet sich im Übergangsbereich zwischen der Lotstoppschicht 2, 4 und der Kontaktschicht 3, 13 ein Saum 8 aus einer von Lot nicht benetzbaren Oxidschicht des für die Lotstoppschicht verwendeten Materials, d.h. ein Saum 8 aus Chromoxid oder Nickeloxid, aus.

Die Dicke des Saums 8 kann durch die Tempertemperatur sowie die Temperzeit eingestellt werden. Mit zunehmender Tempertemperatur und zunehmender Temperzeit nimmt die Dicke des Saums 8 zu.

Diesem Verfahren liegen folgende physikalische und chemische Erfahrungstatsachen zugrunde. Tempert man eine Goldschicht mit einer darunter liegenden Nickel-, Chrom- oder Nickel/Chromschicht bei den oben erwähnten Bedingungen, so diffundieren die Elemente Nickel und Chrom durch die Goldschicht hindurch. Aus Experimenten ist bekannt, daß bei den obengenannten Temperbedingungen Nickel und Chrom durch eine mehrere µm dicke Goldschicht hindurch diffundieren. Im Inneren der Goldschicht findet man danach mit tiefenanalytischen Methoden (SIMS) nur eine geringe Konzentration von Nickel und Chrom. An der Oberfläche der Goldschicht findet eine Reaktion des Chroms bzw. Nickels mit dem Sauerstoff der Luft statt, so daß dort Chromoxid bzw. Nickeloxid entsteht. Diese Oxide sind in der Goldschicht nahezu unbeweglich. Als Folge hiervon reichert sich das Chrom bzw. Nickel als Oxid auf der Goldoberfläche an der Grenze zu Luft während des Diffusions- und Reaktionsprozesses an. Solche Schichten sind nicht von Lot benetzbar.

Hochschmelzende Elemente wie Titan, Wolfran, Tantal oder Molybdän weisen dagegen nur eine sehr geringe Diffusion in der Goldschicht auf. Daher findet ein oben beschriebener Diffusions- und Reaktionsprozeß dieser Elemente nicht statt, und eine Goldschicht mit einer Haftschicht aus diesen Elementen bleibt auch nach der Temperung lötbar.

Diese Erkenntnis wird nun in dem oben beschriebenen Verfahren zur Herstellung von Lothöckern definierter Größe ausgenutzt. In der Haftschicht 2 unter der Goldschicht 3 werden die obenerwähnten hochschmelzenden Elemente und deren Verbindung verwendet (Tantalnitrid, Titan/Wolfram, Molybdän). Die Goldschicht im Innern der Öffnung 6 bleibt daher auch nach dem erfindungsgemäßen Temperprozeß lötbar. Für die Lotstoppschicht 4 werden - wie oben ebenfalls beschrieben - die Elemente Nickel, Chrom oder Nickel/Chrom verwendet. An der Grenzfläche zu der Kontaktschicht 3, 13 aus Gold findet dann während der Temperung eine Diffusion dieser Elemente in vertikaler sowie auch in lateraler Richtung in der aus Gold bestehenden Kontaktschicht 3, 13 statt. Eine Oxidation von Nickel und Chrom kann nur am Rand 7 der Öffnung 6 erfolgen, da nur hier Kontakt zu Luft-Sauerstoff besteht. Das in der Goldschicht vom Rand 7 unter die Öffnung 6 diffundierende Chrom bzw. Nickel oxidiert daher unmittelbar am Rand und bildet dort eine Diffusionssenke in Form des Saumes 8, die aus Nickeloxid bzw. Chromoxid besteht (vgl. Fig. 1 und Fig. 1a). Dieser Saum 8 um die Öffnung 6 ist von Lot nicht benetzbar. Hierdurch wird erreicht, daß die Lotstoppschicht 4, 14 wirksam vor einem "Unterwandern" des flüssigen Lotes beim Aufschmelz- oder Kontaktierungsprozeß geschützt ist.

Ein entsprechender Schichtaufbau und die gleichen Temperbedingungen werden auch im Schichtsystem des zu montierenden Bauelementchips 11 eingesetzt. Der Lothöcker 5 kann sowohl auf dem Substrat 1 als auch auf dem Bauelement 11 auf die beschriebene Weise hergestellt werden.

Die Lotstoppschicht 4 kann gleichzeitig auch als Haftschicht für eine weitere, darüber liegende Isolationsschicht bei Vielschichtsystemen mit mehreren Leiterebenen verwendet werden. In Fig. 2 ist hierzu ein Beispiel für Hochfrequenzanwendungen dargestellt. Auf dem Substrat 1 ist über der unteren Haftschicht 2 und der unteren Kontaktschicht 3 eine durch eine dicke Polyimidschicht 21 elektrisch isolierte obere Goldschicht 23 zur Herstellung von Mikrochip-Wellenleitern oder grounded group Planar-Wellenleitern erforderlich. Da Polyimidschichten auf Gold nur eine geringe Haftfestigkeit besitzen, kann die Lotstoppschicht 4 gleichzeitig als Haftschicht für eine darüberliegende Polyimidschicht verwendet werden. Da diese Polyimidschicht 21, die als Isolationsschicht wirkt, nicht zur lateralen Begrenzung der Kontaktflächen für Lothöcker 15 benutzt werden muß, kann sie von der Öffnung 6 zurückgesetzt sein und eine größere Dicke aufweisen, ohne daß die Positionierung der Lothöcker 15 dadurch beeinträchtigt wird.

So ist beispielsweise für Hochfrequenzleitungen im Frequenzbereich um 10 GHz eine Dicke der Polyimidschicht 21 von 10 bis 30 µm erforderlich. Würde man eine derartige Schicht als Lotstoppschicht 4 verwenden, so könnten die Lothöcker 15 bei einer geringen Fehlpositionierung die Kontaktflächen 9 nicht berühren. Durch die oben beschriebene Herstellung der Lothöcker unter Verwendung der Lotstoppschicht 4, 14 und des Saumes 8 kann nun aber - wie beschrieben - die dicke Isolationsschicht 21 so weit von der Öffnung 6 zurückgesetzt werden, daß eine Beeinträchtigung der Lothöckerpositionierung ausgeschlossen ist.

Ein weiterer Vorteil des oben beschriebenen Verfahrens liegt darin, daß die Schichten gleichzeitig als Höhenanschlag bei der Chipmontage dienen können. Die Summe der Dicken der Schichten zwischen der Grundfläche 19 und der Kontaktfläche 9 muß dabei geringer sein als die Höhe der Lothöcker 15 im aufgeschmolzenen Zustand und größer als die Höhe, die die Lothöcker 15 nach der Benetzung der Kontaktfläche 9 ohne Höhenanschlag einnehmen würde.

Beide Höhen lassen sich durch die Wahl des Lotvolumens und die Größe der durch die Öffnungen 6 bestimmten Kontaktflächen 9 einstellen. Um eventuelle Kurzschlüsse zwischen einer oberen Leiterschicht 23 und der metallischen Lotstopschicht 14 zu verhindern, werden an mindestens drei Stellen innerhalb der Chip-Überdekkungsfläche isolierende Auflage- und Abstandselemente 24 auf der oberen Leiterbahn 23 angeordnet, deren Dicke in die oben genannte Dickensumme eingerechnet werden muß. Diese Auflage- und Abstandselemente können auch an den komplementären Stellen auf dem aufzubringenden Chip 11 angeordnet werden. Die Höhe des Chips 11 über dem Substrat 1 wird durch die Dicken der Schichten bestimmt.

## Patentansprüche

1. Verfahren zur Herstellung von Lothöckern (5, 15) definierter Größe, wobei man auf einem Substrat (1) eine von Lot benetzbare Kontaktschicht (3, 13) aufbringt und wobei man zylinderförmige Lotsäulen auf der Kontaktschicht (3, 13) strukturiert und diese anschließend durch Erwärmen in einen Lothökker (5, 15) von im wesentlichen kugelkappenförmiger Gestalt umschmelzt, gekennzeichnet durch folgende Schritte:
Man bringt auf die Kontaktschicht (3, 13) eine von Lot nicht benetzbare, oxidierbare Lotstoppschicht (4, 14) auf, welche Öffnungen (6, 16) vorgegebener Größe aufweist,
man tempert das Substrat (1) zusammen mit sämtlichen auf ihm aufgebrachten Schichten vor der Strukturierung der Lotsäulen in Luft temperaturgesteuert derart, daß im Übergangsbereich zwischen Lotstoppschicht (4, 14) und Kontaktschicht (3, 13) ein Saum (8) aus einer von Lot nicht benetzbaren Oxidschicht durch Lateraldiffusion der Oxide der Lotstoppschicht entsteht.

2. Verfahren nach Anspruch 1, dadurch gekennzeichnet, daß man als Kontaktschicht (3, 13) eine Goldschicht verwendet.

3. Verfahren nach Anspruch 1 oder 2, dadurch gekennzeichnet, daß man als Lotstoppschicht (4, 14) eine oder mehrere der folgenden Schichten verwendet: Chromschicht, Nickelschicht, Nickel/Chromschicht.

4. Verfahren nach einem der Ansprüche 1 bis 3, dadurch gekennzeichnet, daß die Kontaktschicht (3, 13) eine Dicke von 1 bis 5 µm aufweist.

5. Verfahren nach einem der Ansprüche 1 bis 4, dadurch gekennzeichnet, daß die Lotstoppschicht (4, 14) eine Dicke von 0,2 bis 0,5 µm aufweist.

6. Verfahren nach einem der Ansprüche 1 bis 5, dadurch gekennzeichnet, daß das Tempern bei Temperaturen zwischen 200 und 400 °C und über einen Zeitraum von 2 bis 24 Stunden stattfindet.

7. Verfahren nach einem der Ansprüche 1 bis 6, dadurch gekennzeichnet, daß auf die Lotstoppschicht (4, 14) wenigstens eine Polyimid(PI)-Schicht zu Isolationszwecken aufgebracht wird.
